# EUROPEAN PATENT APPLICATION

(11) **EP 2 837 709 A1**
(43) Date of publication of application: **18.02.2015**
(21) Application number: 14176661.8
(22) Date of filing: 11.07.2014
(51) Int. Cl.: C23C 14/08, C23C 14/34, H01J 37/34

(54) **Method of manufacturing target for sputtering and method of manufacturing organic light-emitting display apparatus**

(30) Priority: 13.08.2013 KR 20130096105
(71) Applicant: Samsung Display Co., Ltd., Gyeonggi-Do (KR)
(72) Inventor: Jung, Sun-Young, Gyeonggi-Do (KR); Shin, Sang-Wook, Gyeonggi-Do (KR); Lee, Il-Sang, Gyeonggi-Do (KR); Kim, Dong-Jin, Gyeonggi-Do (KR); Park, Jin-Woo, Gyeonggi-Do (KR)
(74) Representative: Taor, Simon Edward William

(57) **Abstract**

A method of manufacturing a sputtering target includes: preparing a sputtering target material including a low temperature viscosity transition (LVT) inorganic material, melting the sputtering target material at a working pressure that is lower than atmospheric pressure, and processing the melted sputtering target material to thereby form the sputtering target.

## Description

The present disclosure relates to a method of manufacturing a target for sputtering and a method of manufacturing an organic light-emitting display apparatus.

Recently, various types of display apparatuses have been used. Specifically, thin and lightweight display apparatuses tend to be widely used. An organic light-emitting display apparatus can be a thin and lightweight display apparatus. Such display apparatuses are a self-emission type having, for example, good power consumption, good viewing angles, good image quality, and the like.

An organic light-emitting display apparatus typically includes an organic light-emitting device having a first electrode, a second electrode, and at least an organic emission layer disposed therebetween.

The organic light-emitting device may be susceptible to external moisture and heat, and thus, an encapsulation structure for encapsulating the organic light-emitting device is used.

Various methods are used to form the encapsulation structure. One such method used to form the encapsulation structure is, for example, a sputtering method. The sputtering method is performed using, for example, a sputtering target including materials for the encapsulation structure. A process of manufacturing the sputtering target may influence an increase in the characteristics of the encapsulation structure.

Exemplary embodiments of the present invention include a method of manufacturing a sputtering target and a method of manufacturing an organic light-emitting display apparatus.

According to an embodiment of the present invention, a method of manufacturing a sputtering target includes: preparing a sputtering target material including a low temperature viscosity transition (LVT) inorganic material, melting the sputtering target material at a working pressure that is lower than atmospheric pressure, and processing the melted sputtering target material to thereby form the sputtering target.

The working pressure for melting the sputtering target material may be no greater than about 1000 Pa.

The melting of the sputtering target material may further include: performing a first temperature maintaining operation for maintaining a working temperature at a first temperature, and performing a second temperature maintaining operation for maintaining the working temperature at a second temperature that is higher than the first temperature, after the first temperature maintaining operation.

The melting of the sputtering target material may further include gradually reducing the working pressure during the first temperature maintaining operation and gradually reducing the working pressure during the second temperature maintaining operation.

The working pressure may be no greater than about 1 Pa during the first temperature maintaining operation and the second temperature maintaining operation.

The melting of the sputtering target material may further include increasing the working pressure and the working temperature after the first temperature maintaining operation and until the second temperature maintaining operation.

The melting of the sputtering target material may further include increasing the working pressure and the working temperature until the first temperature maintaining operation.

The melting of the sputtering target material may further include a third temperature maintaining operation for maintaining the working temperature at a third temperature that is higher than the second temperature after the second temperature maintaining operation.

The working pressure may be maintained constant during the third temperature maintaining operation.

The melting of the sputter target material may further include increasing the working pressure and reducing the working temperature after the third temperature maintaining operation.

The method may further include manufacturing powder for forming the sputtering target by using the melted sputtering target material before the processing of the melted sputtering target material.

The LVT inorganic material of the sputtering target material may include a tin oxide.

The LVT inorganic material may include a tin oxide and at least one other material selected from the group consisting of phosphorous oxide (P₂O₅), boron phosphate (BPO₄), tin fluoride (SnF₂), niobium oxide (NbO), and tungsten oxide (WO₃).

The method may comprise melting the sputtering target material in a vacuum state.

The melting operation may include performing a first temperature maintaining operation for maintaining a working temperature at a first temperature. The first temperature may be about 300 ° C to about 400 ° C for a time of about 1 hour to about 2 hours.

The melting operation may include performing a second temperature maintaining operation for maintaining the working temperature at a second temperature, after the first temperature maintaining operation. The second temperature may be about 800 ° C to about 850 ° C for a time of about 30 minutes to about 1 hour.

The melting operation may include performing a third temperature maintaining operation for maintaining the working temperature at a third temperature after the second temperature maintaining operation. The third temperature may be about 1000 ° C to about 1200 ° C.

The method may comprise processing the melted sputtering target material by cooling and drying the melted sputtering target material and cutting the dried sputtering target material into a desired shape to thereby form the sputtering target.

According to an embodiment of the present invention, a method of manufacturing an organic light-emitting display apparatus includes: forming an organic light-emitting device on a substrate. The organic light-emitting device includes a first electrode, a second electrode, and an intermediate layer including at least an organic emission layer. In addition, the method further includes forming a thin-film encapsulation layer on the organic light-emitting device. The thin-film encapsulation layer includes an inorganic layer including a low temperature viscosity transition (LVT) inorganic material. The thin-film encapsulation layer is formed in a sputtering method using a sputtering target, and the sputtering target includes the LVT inorganic material.

The sputtering target may be manufactured by melting a sputtering target material including the LVT inorganic material at a working pressure that is lower than atmospheric pressure.

The working pressure for melting the sputtering target material may be no greater than about 1000 Pa.

The melting of the sputtering target material may further include: performing a first temperature maintaining operation for maintaining a working temperature at a first temperature, and performing a second temperature maintaining operation for maintaining the working temperature at a second temperature that is higher than the first temperature after the first temperature maintaining operation.

The melting of the sputtering target material may further include gradually reducing the working pressure during the first temperature maintaining operation and gradually reducing the working pressure during the second temperature maintaining operation.

The working pressure may be no greater than about 1 Pa during the first temperature maintaining operation and the second temperature maintaining operation.

The LVT inorganic material of the sputtering target material may include a tin oxide.

The forming of the thin-film encapsulation layer may include: forming a preliminary thin-film encapsulation layer in the sputtering method using the sputtering target including the LVT inorganic material, and healing the preliminary thin-film encapsulation layer. The healing of the preliminary thin-film encapsulation layer may be performed at a temperature that is no less than a viscosity transition temperature of the LVT inorganic material and lower than a denaturalization temperature of a material of the intermediate layer in the organic light-emitting device. In accordance with an exemplary embodiment of the present invention, a method of manufacturing a sputtering target is provided. The method includes preparing a sputtering target material including a low temperature viscosity transition (LVT) inorganic material, in which the LVT inorganic material includes a tin oxide and at least one other material selected from the group consisting of phosphorous oxide (P₂O₅), boron phosphate (BPO₄), tin fluoride (SnF₂), niobium oxide (NbO), and tungsten oxide (WO₃), and melting the sputtering target material in a vacuum state. The melting operation includes performing a first temperature maintaining operation for maintaining a working temperature at a first temperature of about 300 ° C to about 400 ° C for a time of about 1 hour to about 2 hours, and performing a second temperature maintaining operation for maintaining the working temperature at a second temperature of about 800 ° C to about 850 ° C for a time of about 30 minutes to about 1 hour, after the first temperature maintaining operation and performing a third temperature maintaining operation for maintaining the working temperature at a third temperature of about 1000 ° C to about 1200 ° C, after the second temperature maintaining operation.

In addition, the method further includes processing the melted sputtering target material by cooling and drying the melted sputtering target material and cutting the dried sputtering target material into a desired shape to thereby form the sputtering target.

According to an aspect of the invention, there is provided a method of manufacturing a sputtering target as set out in claim 1. Preferred features are set out in claims 2 to 12.

According to an aspect of the invention, there is provided a method of manufacturing an organic light-emitting display apparatus as set out in claim 13. Preferred features are set out in claim 14 and 15.

Exemplary embodiments of the present invention can be understood in more detail from the following description taken in conjunction with the accompanying drawings in which:
FIG. 1 is a schematic perspective view of a sputtering target manufactured by a method according to an embodiment of the present invention;
FIG. 2 is a flowchart illustrating a method of manufacturing a sputtering target according to an embodiment of the present invention;
FIG. 3 is a flowchart illustrating a method of manufacturing a sputtering target according to an embodiment of the present invention;
FIG. 4 illustrates graphs showing changes in pressure and temperature according to time in a melting operation of a process of manufacturing a sputtering target by using the sputtering target manufacturing method of FIGS. 2 or 3;
FIG. 5 illustrates a method of manufacturing an organic light-emitting display apparatus by using the sputtering target of FIG. 1 according to an embodiment of the present invention;
FIG. 6 is a schematic cross-sectional view of an organic light-emitting display apparatus manufactured by the method of FIG. 5 according to an embodiment of the present invention;
FIG. 7 is a schematic cross-sectional view of an organic light-emitting display apparatus according to an embodiment of the present invention; and
FIG. 8 is a schematic cross-sectional view of an organic light-emitting display apparatus according to an embodiment of the present invention.

Reference will now be made in detail to exemplary embodiments, examples of which are illustrated in the accompanying drawings, wherein like reference numerals refer to the like elements throughout. In this regard, exemplary embodiments of the present invention may have different forms and should not be construed as being limited to the descriptions set forth herein.

It will be further understood that the terms "comprises" and/or "comprising" used herein specify the presence of stated features or components, but do not preclude the presence or addition of one or more other features or components.

It will be understood that when a layer, region, or component is referred to as being "formed on" another layer, region, or component, it can be directly or indirectly formed on the other layer, region, or component. That is, for example, intervening layers, regions, or components may be present.

Sizes of elements in the drawings may be exaggerated for convenience of explanation. In other words, as sizes and thicknesses of components in the drawings are arbitrarily illustrated for convenience of explanation, exemplary embodiments are thus not limited thereto.

Embodiments will now be described in detail with reference to the accompanying drawings. Like reference numerals in the drawings denote like elements, and thus their repetitive description will be omitted.

As used herein, the term "and/or" includes any and all combinations of one or more of the associated listed items. Expressions such as "at least one of," when preceding a list of elements, modify the entire list of elements and do not modify the individual elements of the list. As used herein, the singular forms, "a", "an", and "the" are intended to include plural forms as well, unless the context clearly indicates otherwise.

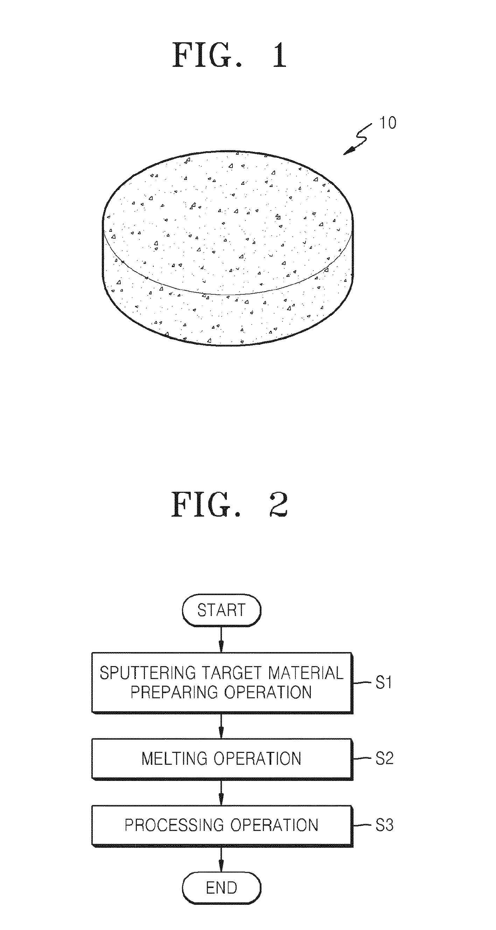

FIG. 1 is a schematic perspective view of a sputtering target 10 manufactured by a method according to an embodiment of the present invention.

Referring to FIG. 1, the sputtering target 10 has a shape that is, for example, similar to a circular plate. However, the circular plate shape is only an illustration, and thus alternatively, in an embodiment, the sputtering target 10 may have, for example, a square shape or a cylindrical shape.

The sputtering target 10 includes, for example, a low temperature viscosity transition (LVT) inorganic material.

In the specification, the term "viscosity transition temperature" does not refer to a temperature at which the LVT inorganic material is fully converted from a solid state to a liquid state, but refers to a minimum temperature at which the LVT inorganic material becomes fluid, e.g.., a minimum temperature at which the viscosity of the LVT inorganic material changes. The detailed description of the "viscosity transition temperature" of the LVT inorganic material will be made below.

For example, the viscosity transition temperature of the LVT inorganic material may be about 80°C or above, e.g., equal to or higher than about 80°C and lower than about 132°C, but exemplary embodiments are not limited thereto. For example, the viscosity transition temperature of the LVT inorganic material may be about 80°C to about 120°C or about 100°C to about 120°C, but exemplary embodiments are not limited thereto. For example, the viscosity transition temperature of the LVT inorganic material may be about 110°C.

The LVT inorganic material may be made up of one compound or a mixture formed of two or more compounds.

The LVT inorganic material may include, for example, a tin oxide (for example, SnO or SnO₂). When the LVT inorganic material includes SnO, the SnO content may be, for example, about 20 wt% to about 100 wt%.

The LVT inorganic material may further include, for example, at least one of a phosphorous oxide (e.g., P₂O₅), a boron phosphate (BPO₄), a tin fluoride (e.g., SnF₂), a niobium oxide (e.g., NbO), and a tungsten oxide (e.g., WO₃) in addition to the tin oxide.

For example, the LVT inorganic material may include:
SnO;
SnO and P₂O₅;
SnO and BPO₄;
SnO, SnF₂, and P₂O₅;
SnO, SnF₂, P₂O₅, and NbO; or
SnO, SnF₂, P₂O₅, and WO₃, but exemplary embodiments are not limited thereto.

FIG. 2 is a flowchart illustrating a method of manufacturing a sputtering target according to an embodiment of the present invention. For example, FIG. 2 may illustrate the method of manufacturing the sputtering target 10 of FIG. 1.

Referring to FIG. 2, the current embodiment includes, for example, a sputtering target material preparing operation S1, a melting operation S2, and a processing operation S3.

The sputtering target material preparing operation S1 is an operation of preparing the LVT inorganic material described above. That is, in the sputtering target material preparing operation S1, materials including a tin oxide (for example, SnO or SnO₂) are prepared, or alternatively materials including at least one of a phosphorous oxide (e.g., P₂O₅), a boron phosphate (BPO₄), a tin fluoride (e.g., SnF₂), a niobium oxide (e.g., NbO), and a tungsten oxide (e.g., WO₃) in addition to the tin oxide are prepared. In this case, these materials may be prepared in a solid state.

The melting operation S2 is an operation of melting the materials prepared by the sputtering target material preparing operation S1 such as, for example, solid materials. In the melting operation S2, impurities are completely removed while melting the materials prepared by the sputtering target material preparing operation S1.

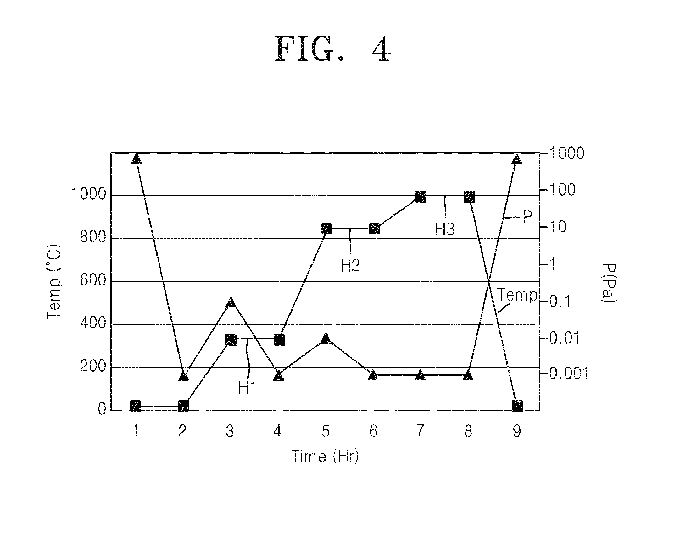

The melting operation S2 is performed at a pressure that is, for example, at least lower than the atmospheric pressure, e.g., in a vacuum state. The melting operation S2 is described in detail with reference to FIG. 4.

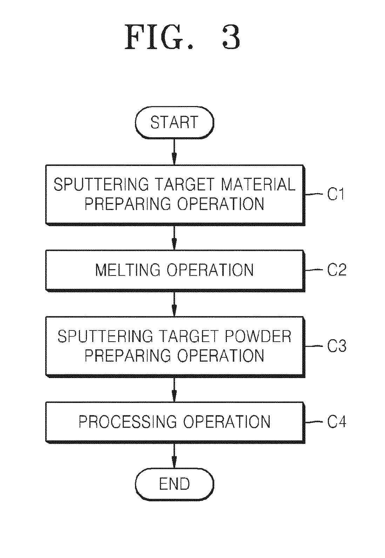

FIG. 4 illustrates graphs showing changes in working pressure and working temperature according to time in a melting operation of a process of manufacturing a sputtering target by using the sputtering target manufacturing method of FIG. 2 or FIG. 3 to be described below.

Referring to FIG. 4, the X axis indicates hours, and the Y axis indicates pressure and temperature. The unit of pressure is pascal (Pa), and the unit of temperature is °C.

In FIG. 4, a graph displayed with rectangular dots indicates changes in working temperature according to time during the melting operation S2, and a graph displayed with triangular dots indicates changes in working pressure according to time during the melting operation S2.

As shown in FIG. 4, the melting operation S2 is performed at a working pressure of, for example, about 1000 Pa or less. That is, the melting operation S2 is performed in a vacuum state that is lower than the atmospheric pressure. The melting operation S2 in a vacuum state fundamentally prevents a decrease in the purity of the materials of the sputtering target which may occur due to the oxidization of the materials of the sputtering target in the air. Specifically, a sputtering target having a high purity of a desired component may be manufactured without contamination by readily preventing abnormal oxidization of a tin oxide material included in the LVT inorganic material described above.

The melting operation S2 includes, for example, at least a first temperature maintaining operation H1 and a second temperature maintaining operation H2 to melt the materials of the sputtering target.

The first temperature maintaining operation H1 maintains a temperature, e.g., about 300°C to about 400°C. Up until the first temperature maintaining operation H1, the working temperature gradually increases, and the working pressure increases. A working temperature increasing time and a working pressure increasing time up until the first temperature maintaining operation H1 may be properly determined according to types and amounts of the materials of the sputtering target.

During the first temperature maintaining operation H1, the working temperature is maintained at, for example, a constant temperature, e.g., about 350°C. After the first temperature maintaining operation H1, the working temperature gradually increases.

When the materials of the sputtering target are melted during the first temperature maintaining operation H1, almost all impurities are discharged in a gaseous state from the materials of the sputtering target. For example, when a phosphorous oxide (e.g., P₂O₅) among the materials of the sputtering target is melted, impurities are outgassed from the phosphorous oxide. During the time corresponding to the first temperature maintaining operation H1, the working pressure gradually decreases. For example, the working pressure is reduced to about 0.1 Pa to about 0.001 Pa, that is, a relatively high vacuum state is maintained. The outgassed impurities are readily removed at this low pressure, e.g., in a relatively high vacuum state. To readily remove the impurities, the first temperature maintaining operation H1 is maintained for a sufficient time such as, for example, for about one hour to about two hours.

After the first temperature maintaining operation H1, the working temperature gradually increases, and the working pressure gradually increases.

Thereafter, the second temperature maintaining operation H2 is performed.

The second temperature maintaining operation H2 maintains a temperature, e.g., a second temperature of about 800°C to about 850°C. Up until the second temperature maintaining operation H2, the working temperature gradually increases. During the second temperature maintaining operation H2, the working temperature is constantly maintained at a predetermined temperature, e.g., about 830°C. After the second temperature maintaining operation H2, the working temperature gradually increases.

When the materials of the sputtering target are melted during the second temperature maintaining operation H2, all impurities still existing in the materials of the sputtering target are finally discharged in a gaseous state. During the second temperature maintaining operation H2, the working pressure gradually decreases. For example, the working pressure is reduced to about 0.01 Pa to about 0.001 Pa, such that a relatively high vacuum state results. The outgassed impurities are readily removed at this low pressure, e.g., in a high vacuum state. To readily remove the impurities, the second temperature maintaining operation H2 maintains the second temperature for a time sufficient such as for example, for about thirty minutes to about one hour. As the majority of the impurities were removed in a vacuum state during the first temperature maintaining operation H1, the second temperature maintaining operation H2 may be performed for a shorter time than the first temperature maintaining operation H1.

The current embodiment may selectively include, for example, a third temperature maintaining operation H3. The third temperature maintaining operation H3 maintains a temperature, e.g., a third temperature of about 1000°C to about 1200°C. Up until the third temperature maintaining operation H3, the working temperature gradually increases. That is, the working temperature gradually increases after the second temperature maintaining operation H2, and a constant temperature, e.g., about 1000°C, is maintained during the third temperature maintaining operation H3. The third temperature maintaining operation H3 is the final operation of the melting operation S2, and after the third temperature maintaining operation H3, the working temperature is reduced to the normal temperature.

During the third temperature maintaining operation H3, the materials of the sputtering target are uniformly melted to form uniform melted materials. The working pressure may be uniformly maintained throughout the third temperature maintaining operation H3 during the third temperature maintaining operation H3. For example, the working pressure is maintained at about 0.001 Pa or less, such that a relatively high vacuum state is maintained. The materials of the sputtering target are melted for an appropriate time in a working atmosphere in which pressure and temperature are appropriate for uniformly melting the materials for the sputtering target. Finally, the third temperature maintaining operation H3 is performed so that all materials are uniformly melted and mixed.

After the third temperature maintaining operation H3, the pressure increases and the temperature decreases to thereby complete the melting operation S2. The time necessary for increasing the pressure and the temperature (e.g., a pressure increasing time and a temperature decreasing time) after the third temperature maintaining operation H3 may be properly determined based on the materials of the sputtering target.

After the melting operation S2, the processing operation S3 is performed. The processing operation S3 includes an operation of manufacturing the sputtering target by processing the melted materials of the sputtering target which are obtained by performing the melting operation S2. The processing operation S3 may include various processes. For example, the processing operation S3 may include an operation of cooling and drying the melted materials of the sputtering target and an operation of manufacturing the sputtering target by cutting the dried materials into a desired shape. However, the processing operation S3 is only illustrative, and various types of processing operations may be included to manufacture various sputtering targets.

FIG. 3 is a flowchart illustrating a method of manufacturing a sputtering target according to an embodiment of the present invention. For example, FIG. 3 may illustrate the method of manufacturing the sputtering target 10 of FIG. 1.

Referring to FIG. 3, the current embodiment includes, for example, a start, a sputtering target material preparing operation C1, a melting operation C2, a sputtering target powder preparing operation C3, a processing operation C4, and an end. For convenience of description, differences between the method of FIG. 2 described above and the method of the present embodiment are mainly described.

The sputtering target material preparing operation C1 is an operation of preparing the LVT inorganic material described above. The detailed description thereof is the same as described with reference to FIG. 2.

The melting operation C2 is an operation of melting the materials prepared by the sputtering target material preparing operation C1 such as, for example, solid materials. In the melting operation C2, impurities are completely removed while melting the materials prepared by the sputtering target material preparing operation C1.

The melting operation C2 is performed at a pressure that is, for example, at least lower than the atmospheric pressure, e.g., in a vacuum state. The detailed description thereof is the same as described with reference to FIG. 2, and thus, a repeated description thereof is omitted. That is, the same changes in temperature and pressure according to time, and under a given atmosphere, as in the graphs of FIG. 4, are applied to the melting operation C2 according to the current embodiment.

After the melting operation C2, the sputtering target powder preparing operation C3 is performed. Powders for the sputtering target having a proper particle size are obtained by, for example, cooling or drying or by cooling and drying the melted materials of the sputtering target.

After the sputtering target powder preparing operation C3, the processing operation C4 is performed. The processing operation C4 may include various processes. For example, the processing operation C4 may include an operation of melting materials in the form of powder and an operation of manufacturing the sputtering target by cooling and drying the melted materials and cutting the dried materials into a desired shape. However, the processing operation C4 is only illustrative, and various types of processing operations may be included to manufacture various sputtering targets.

When the methods of manufacturing a sputtering target according to embodiments described above are used, the oxidization of the materials of the sputtering target, such as, for example, an LVT inorganic material, is fundamentally prevented during the melting thereof by performing a melting operation at a pressure that is lower than the atmospheric pressure, e.g., at a vacuum atmosphere, in a process of manufacturing the sputtering target.

According to exemplary embodiments, as a melting operation of a method of manufacturing a sputtering target includes a first temperature maintaining operation and a second temperature maintaining operation, materials of the sputtering target are uniformly melted. As a working pressure is reduced in the first and second temperature maintaining operations, impurity gases outgassed from the materials of the sputtering target during the melting thereof are readily removed from the melted materials of the sputtering target and a working space therein. Accordingly, a sputtering target efficiently exhibiting a desired characteristic may be manufactured, and thus, a sputtering characteristic and a characteristic of a thin film formed through sputtering are increased.

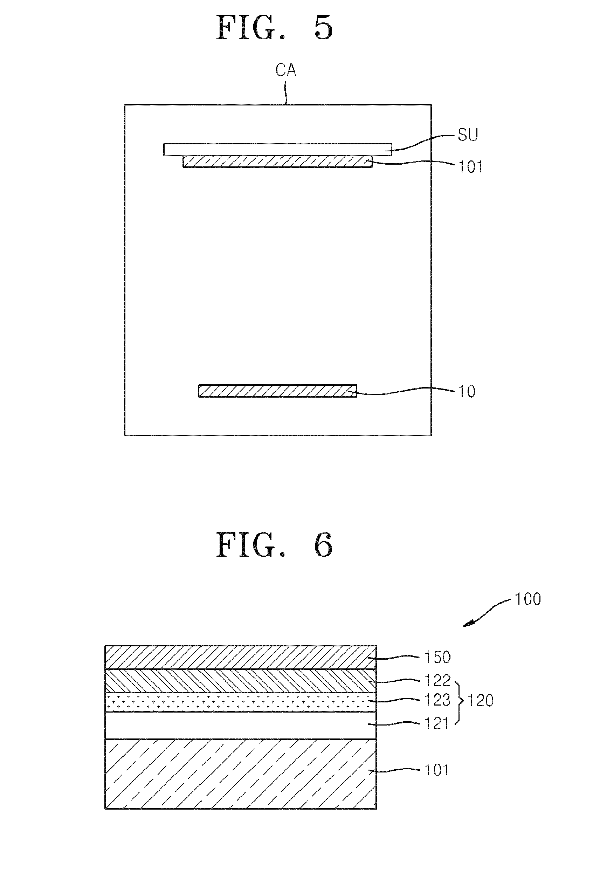

FIG. 5 illustrates a method of manufacturing an organic light-emitting display apparatus by using the sputtering target 10 of FIG. 1 according to an embodiment of the present invention.

Referring to FIG. 5, the sputtering target 10 described above and a substrate 101 are arranged in a chamber CA. The substrate 101 is disposed on a stage unit SU, and the sputtering target 10 is disposed to face the substrate 101. A thin film including materials forming the sputtering target 10 may be formed on the substrate 101 by, for example, performing a sputtering method using the sputtering target 10. For example, a thin-film encapsulation layer may be formed on the substrate 101.

The structure shown in FIG. 5 is merely an example structure used in a sputtering method, and the current embodiment is not limited thereto. That is, an organic light-emitting display apparatus may be manufactured by performing various sputtering methods using the sputtering target 10.

For example, alternatively in an embodiment, two sputtering targets 10 are disposed to face each other such that plasma is formed in a space between the two sputtering targets 10, the substrate 101 is disposed to face the plasma, and a sputtering method is performed, and damage due to particle collisions on the substrate 101 is thus prevented.

FIG. 6 is a schematic cross-sectional view of an organic light-emitting display apparatus 100 manufactured by the method of FIG. 5, according to an embodiment of the present invention.

Referring to FIG. 6, the organic light-emitting display apparatus 100 may include, for example, the substrate 101, an organic light-emitting device 120, and a thin-film encapsulation layer 150 having at least one inorganic layer including an LVT inorganic material.

The substrate 101 may be formed using various materials. For example, the substrate 101 may be formed of a transparent glass material including silicon oxide (SiO₂) as a main component. Alternatively, in an embodiment, the substrate 101 may be formed of, for example, a plastic material or a quartz material. Further, in an embodiment, the substrate 101 may be, for example, a flexible substrate. Suitable materials for the flexible substrate include, for example, polyethylenenaphthalate, polyethylene terephthalate, polyacryl, polyimide, polyethersulfone, polyvinyl chloride, or combinations thereof.

The organic light-emitting device 120 is formed on the substrate 101 and may include, for example, a first electrode 121, a second electrode 122, and an intermediate layer 123. For example, the first electrode 121 is formed on the substrate 101, the second electrode 122 is formed on the first electrode 121, and the intermediate layer 123 is formed between the first electrode 121 and the second electrode 122.

In an embodiment, a buffer layer formed of, for example, silicon oxide (SiO₂), silicon nitride (SiNₓ) and/or silicon oxynitride (SiON) may be further formed between the first electrode 121 and the substrate 101. The buffer layer may provide a planarized surface onto the substrate 101 and prevent moisture or gases from infiltrating through the substrate 101 and into the first electrode 121.

The first electrode 121 may function as, for example, an anode, and the second electrode 122 may function as, for example, a cathode. Alternatively, in an embodiment, the polarities thereof may be vice versa.

When the first electrode 121 functions as an anode, the first electrode 121 may include, for example, an indium tin oxide (ITO), an indium zinc oxide (IZO), a zinc oxide (ZnO), an indium oxide (In₂O₃), or the like having a large work function. According to a purpose and a design condition related to the organic light-emitting device 120, the first electrode 121 may further include, for example, a reflective layer formed of silver (Ag), magnesium (Mg), aluminum (Al), platinum (Pt), palladium (Pd), gold (Au), nickel (Ni), neodymium (Nd), iridium (Ir), chromium (Cr), lithium (Li), ytterbium (Yb), calcium (Ca), aluminum-lithium (Al-Li), magnesium-Indium (Mg-In), magnesium-silver (Mg-Ag), or the like.

When the second electrode 122 functions as a cathode, the second electrode 122 may be formed of, for example, a metal, such as Ag, Mg, Al, Pt, Pd, Au, Ni, Nd, Ir, Cr, Li, Ca, Al-Li, Mg-In, or Mg-Ag. Alternatively, in an embodiment, the second electrode 222 may include, for example, an optical-transmissive metal, such as ITO, IZO, ZnO, In₂O₃, or the like.

The intermediate layer 123 includes, for example, at least an organic emission layer. The intermediate layer 123 may further selectively include, for example, at least one of a hole injection layer (HIL), a hole transport layer (HTL), an electron transport layer (ETL), and an electron injection layer (EIL) in addition to the organic emission layer.

When a voltage is applied to the first electrode 121 and the second electrode 122, visible rays are emitted from the intermediate layer 123, such as from the organic emission layer therein.

In an embodiment, the organic light-emitting display apparatus 100 may include, for example, at least one thin film transistor electrically connected to the organic light-emitting device 120. The organic light-emitting display apparatus 100 may include, for example, at least one capacitor electrically connected to the organic light-emitting device 120.

In addition, for example, in an embodiment, at least one planarization layer or protective layer may be formed between the organic light-emitting device 120 and the thin-film encapsulation layer 150. The planarization layer or protective layer provides a planarized surface on the organic light-emitting device 120 and primarily protects the organic light-emitting device 120. The planarization layer or protective layer may be formed using various insulating materials such as, for example, an organic material. For example, in an embodiment, the planarization layer may be formed of a material selected from the group consisting of benzocyclobutene (BCB), polyimide (PI), polyamide (PA), an acrylic resin and a phenolic resin. Also, in an embodiment, the protective layer may be formed of, for example, an inorganic insulating layer having a silicon oxide (SiO₂) layer, a silicon nitride (SiNx) layer or a stacked structure thereof.

The thin-film encapsulation layer 150 is formed on the organic light-emitting device 120.

The thin-film encapsulation layer 150 includes, for example, an LVT inorganic material.

The thin-film encapsulation layer 150 may be formed by, for example, the sputtering method using the sputtering target 10 as shown in FIG. 5. A method of forming the thin-film encapsulation layer 150 will now be described.

First, the substrate 101 is arranged in the chamber CA in which the sputtering target 10 is arranged. In this case, the organic light-emitting device 120 is formed on the substrate 101, and the planarization layer or protective layer may be further formed on the organic light-emitting device 120.

Next, a preliminary thin-film encapsulation layer for forming the thin-film encapsulation layer 150 is formed by, for example, performing sputtering using the sputtering target 10.

As described above, the sputtering target 10 includes, for example, an LVT inorganic material.

The preliminary thin-film encapsulation layer formed through the sputtering may have various defects, e.g., a deposition element, a pinhole, and an environmental element. The environmental element may be, as an organic material or an inorganic material, particles attached in one of a plurality of processes for forming the organic light-emitting display apparatus 100. In addition, a defect, such as, for example, a vacant space between the preliminary thin-film encapsulation layer and the organic light-emitting device 120, may occur. The deposition element refers to LVT inorganic material coagulated particles which did not contribute to deposition when the preliminary thin-film encapsulation layer was formed, and the pinhole refers to a region in which no LVT inorganic material is provided.

The defects of the preliminary thin-film encapsulation layer may allow external environmental materials, (e.g., moisture, oxygen, and the like), to pass into the organic light-emitting display apparatus 100, and thus, the defects of the preliminary thin-film encapsulation layer may cause a progressive dark spot to be formed, thereby resulting in a decrease in the life span of the organic light-emitting display apparatus 100.

Thus, after forming the preliminary thin-film encapsulation layer, the thin-film encapsulation layer 150 is finally formed as shown in FIG. 6 by performing, for example, a healing operation.

The healing operation is performed at a temperature that is, for example, equal to or higher than a viscosity transition temperature of the LVT inorganic material. For example, the healing operation may be performed by heat-treating the preliminary thin-film encapsulation layer at a temperature within a range equal to or higher than the viscosity transition temperature of the LVT inorganic material and lower than a denaturalization temperature of a material of an intermediate layer 123 included in the organic light-emitting device 120. Alternatively, in an embodiment, the healing operation may be performed by, for example, heat-treating in the range from the viscosity transition temperature of the LVT inorganic material to a minimum value of metamorphic temperatures of the material included in the intermediate layer 123 of the organic light-emitting device 120. Alternatively, in an embodiment, the healing operation may be performed at, for example, the viscosity transition temperature of the LVT inorganic material. For example, the healing operation may be performed by heat-treating the preliminary thin-film encapsulation layer for about one hour to about three hours at a temperature within a range equal to or higher than about 80°C and lower than about 132°C (e.g., a range of about 80°C to about 120°C or a range of about 100°C to about 120°C), but exemplary embodiments are not limited thereto. When the temperature of the healing operation satisfies the range described above, the fluidity of the LVT inorganic material in the preliminary thin-film encapsulation layer is possible, and the denaturalization of the intermediate layer 123 in the organic light-emitting device 120 is prevented. To prevent the preliminary thin-film encapsulation layer from being exposed to the external environment through a pinhole, the healing operation may be performed, for example, in an infrared (IR) oven at a vacuum atmosphere or an inert gas atmosphere (e.g., a nitrogen (N₂) atmosphere or an argon (Ar) atmosphere).

By the healing operation, the LVT inorganic material included in the preliminary thin-film encapsulation layer may be fluidized. The fluidized LVT inorganic material may have flowability. Thus, in the healing operation, i) the fluidized LVT inorganic material may be flowed and filled into a gap occurring due to the environmental element, ii) the fluidized LVT inorganic material may be flowed and filled into the pinhole, and iii) the deposition element may be fluidized and filled into the pinhole.

Finally, the organic light-emitting display apparatus 100 is completed by forming the thin-film encapsulation layer 150 including the LVT inorganic material.

In an embodiment, the healing operation may be additionally performed. That is, the healing operation may be performed two times to increase the heat-resistance and the mechanical strength of the thin-film encapsulation layer 150.

The thin-film encapsulation layer 150 is formed by, for example, being melted and then solidified as described above, wherein a viscosity transition temperature of the thin-film encapsulation layer 150 is lower than a denaturalization temperature of the intermediate layer 123.

In the specification, the term "viscosity transition temperature" does not refer to a temperature at which the LVT inorganic material is fully converted from a solid state to a liquid state, but refers to a minimum temperature for providing the fluidity to the LVT inorganic material, e.g., a minimum temperature at which the viscosity of the LVT inorganic material changes.

The viscosity transition temperature of the LVT inorganic material may be, for example, lower than a denaturalization temperature of a material included in the intermediate layer 123. For example, the viscosity transition temperature of the LVT inorganic material may be lower than a minimum value of denaturalization temperatures of materials included in the intermediate layer 123.

The denaturalization temperature of the intermediate layer 123 refers to a temperature which may cause physical denaturalization and/or chemical denaturalization of a material included in the intermediate layer 123, and there may exist a plurality of denaturalization temperatures according to types and the number of materials included in the intermediate layer 123. For example, the viscosity transition temperature of the LVT inorganic material and the denaturalization temperature of the intermediate layer 123 may refer to a glass transition temperature Tg of the LVT inorganic material and a glass transition temperature Tg of an organic material included in the intermediate layer 123, respectively.

The glass transition temperatures Tg may be measured by, for example, performing thermo gravimetric analysis (TGA) on the LVT inorganic material and the organic material included in the intermediate layer 123.

A glass transition temperature may be readily determined by those of ordinary skill in the art by, for example, performing thermal analysis (N₂ atmosphere, temperature duration: normal temperature to about 600°C (about 10°C/min)-TGA, normal temperature to about 400°C-differential scanning calorimetry (DSC), pan type: Pt pan-in disposable Al pan (TGA), disposable Al pan (DSC)) using TGA and DSC on the materials included in the intermediate layer 123.

A denaturalization temperature of a material included in the intermediate layer 123 may be higher than, for example, about 130°C, but exemplary embodiments are not limited thereto. The denaturalization temperature of the material included in the intermediate layer 123 may be readily measured by, for example, performing TGA as described above on the material included in the intermediate layer 123.

A minimum value of the denaturalization temperatures of the materials included in the intermediate layer 123 may be, for example, about 130°C to about 140°C. For example, the minimum value of the denaturalization temperatures of the materials included in the intermediate layer 123 may be about 132°C, but exemplary embodiments are not limited thereto. That is, the minimum value of the denaturalization temperatures of the materials included in the intermediate layer 123 may be determined by, for example, obtaining glass transition temperatures Tg through TGA as described above of the materials included in the intermediate layer 123 and selecting a minimum value of the obtained glass transition temperatures Tg.

For example, the viscosity transition temperature of the LVT inorganic material may be within a range equal to or higher than about 80°C and lower than about 132°C, but exemplary embodiments are not limited thereto. For example, the viscosity transition temperature of the LVT inorganic material may be about 80°C to about 120°C or about 100°C to about 120°C, but exemplary embodiments are not limited thereto. For example, the viscosity transition temperature of the LVT inorganic material may be about 110°C.

The LVT inorganic material may include, for example, a tin oxide (for example, SnO or SnO₂). When the LVT inorganic material includes SnO, the SnO content may be, for example, about 20 wt% to about 100 wt%.

For example, the LVT inorganic material may further include at least one of a phosphorous oxide (e.g., P₂O₅), a boron phosphate (BPO₄), a tin fluoride (e.g., SnF₂), a niobium oxide (e.g., NbO), and a tungsten oxide (e.g., WO₃) in addition to the tin oxide, but exemplary embodiments are not limited thereto.

For example, the LVT inorganic material may include:
SnO;
SnO and P₂O₅;
SnO and BPO₄;
SnO, SnF₂, and P₂O₅;
SnO, SnF₂, P₂O₅, and NbO; or
SnO, SnF₂, P₂O₅, and WO₃, but exemplary embodiments are not limited thereto.

For example, the LVT inorganic material may have any one of the compositions below, but exemplary embodiments are not limited thereto:
1) SnO (about 100 wt%);
2) SnO (about 80 wt%) and P₂O₅ (about 20 wt%);
3) SnO (about 90 wt%) and BPO₄ (about 10 wt%);
4) SnO (about 20 wt% to about 50 wt%), SnF₂ (about 30 wt% to about 60 wt%), and P₂O₅ (about 10 wt% to about 30 wt%) (herein, a content sum of SnO, SnF₂, and P₂O₅ is 100 wt%);
5) SnO (about 20 wt% to about 50 wt%), SnF₂ (about 30 wt% to about 60 wt%), P₂O₅ (about 10 wt% to about 30 wt%), and NbO (about 1 wt% to about 5 wt%) (herein a content sum of, SnO, SnF₂, P₂O₅, and NbO is 100 wt%); and
6) SnO (about 20 wt% to about 50 wt%), SnF₂ (about 30 wt% to about 60 wt%), P₂O₅ (about 10 wt% to about 30 wt%), and WO₃ (about 1 wt% to about 5 wt%) (herein, a content sum of SnO, SnF₂, P₂O₅, and WO₃ is 100 wt%).

For example, the LVT inorganic material may include SnO (about 42.5 wt%), SnF₂ (about 40 wt%), P₂O₅ (about 15 wt%), and WO₃ (about 2.5 wt%), but exemplary embodiments are not limited thereto. Various compositions of the LVT inorganic material may be adjusted by controlling a composition of the inorganic material included in the sputtering target, a pressure and temperature of a sputtering process, and a type of gas used in forming an atmosphere of the process.

In the organic light-emitting display apparatus 100, the organic light-emitting device 120 is readily encapsulated by, for example, forming the thin-film encapsulation layer 150. In addition, the organic light-emitting display apparatus 100 may have a good bending characteristic if readily implemented by minimizing the thickness of the thin-film encapsulation layer 150.

The thin-film encapsulation layer 150 includes, for example, the LVT inorganic material, and the LVT inorganic material has fluidity at a relatively low temperature, thereby readily covering the deposition element, the environmental element, and the like and readily encapsulating the organic light-emitting device 120 in the healing operation.

The thin-film encapsulation layer 150 is formed using, for example, a sputtering method. A sputtering target used in the sputtering method is formed by performing a melting operation at a pressure atmosphere having a pressure that is lower than the atmospheric pressure as described above. Accordingly, materials of the sputtering target are not oxidized, and the purity of the sputtering target is increased. As the thin-film encapsulation layer 150 is formed by performing a sputtering method using a sputtering target having a high purity, the possibility of impurities being introduced into the thin-film encapsulation layer 150 is reduced, and an encapsulating characteristic of the thin-film encapsulation layer 150 is readily controlled as desired, thereby increasing the encapsulating characteristic of the thin-film encapsulation layer 150.

As a melting operation of a method of manufacturing a sputtering target includes a first temperature maintaining operation and a second temperature maintaining operation, materials of the sputtering target are uniformly melted. As a working pressure is reduced to that of a vacuum atmosphere in the first and second temperature maintaining operations, impurity gases outgassed from the materials of the sputtering target during melting of the materials are readily removed from the melted materials of the sputtering target and a working space. Accordingly, a sputtering target may be manufactured to have a high purity and be free of impurities. The encapsulating characteristic and durability of the thin-film encapsulation layer 150 are increased using the sputtering target having a high purity. Specifically, in the melting operation of the method of manufacturing a sputtering target, a process is performed at a vacuum atmosphere to prevent oxidization of the materials of the sputtering target, thereby preventing the generation of a crystal phase of the materials of the sputtering target which may be formed due to the oxidization. Accordingly, only a transparent glass phase exists instead of an opaque crystal phase when the thin-film encapsulation layer 150 is formed through sputtering, thereby increasing the optical characteristic of the organic light-emitting display apparatus 100 using the thin-film encapsulation layer 150.

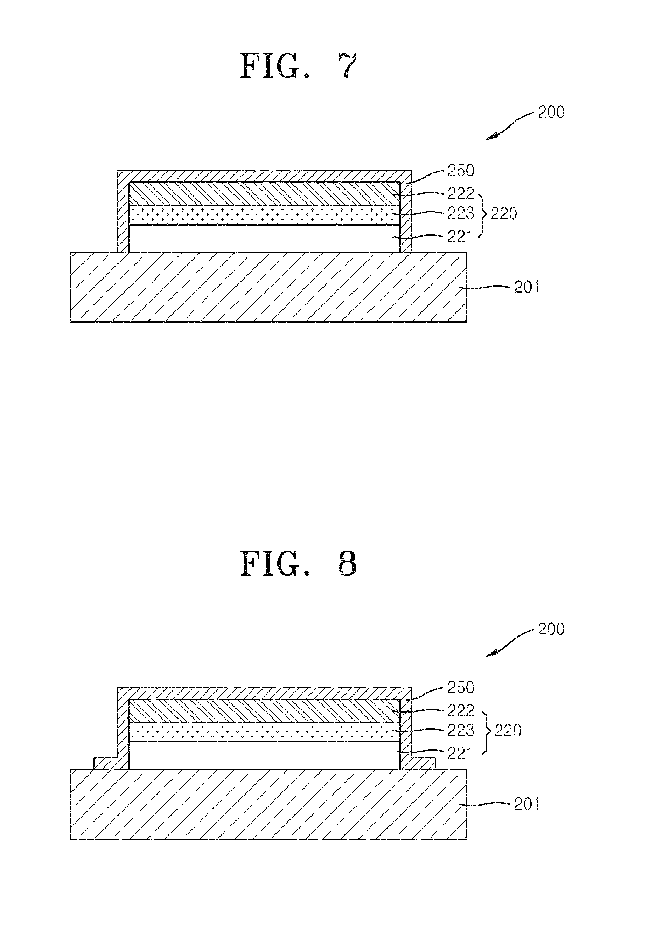

FIG. 7 is a schematic cross-sectional view of an organic light-emitting display apparatus 200 according to an embodiment of the present invention. Referring to FIG. 7, the organic light-emitting display apparatus 200 may include, for example, a substrate 201, an organic light-emitting device 220, and a thin-film encapsulation layer 250.

The organic light-emitting device 220 may include, for example, a first electrode 221, a second electrode 222, and an intermediate layer 223.

For convenience of description, differences between the organic light-emitting display apparatus 100 of FIG. 6 described above and the organic light-emitting display apparatus 200 of the present embodiment will be mainly described.
The structure of the thin-film encapsulation layer 250 of the organic light-emitting display apparatus 200 of the present embodiment is different from the thin-film encapsulation layer 150 of the organic light-emitting display apparatus 100 of FIG. 6 described above in that the thin-film encapsulation layer 250 has a structure which covers the upper and side surfaces of the organic light-emitting device 220. Accordingly, the organic light-emitting device 220 is prevented from being damaged due to moisture, open air, and foreign substances. In addition, the thin-film encapsulation layer 250 contacts the substrate 201. Accordingly, the thin-film encapsulation layer 250 efficiently encapsulates the organic light-emitting device 220. The contacting of the thin-film encapsulation layer 250 with the substrate 201 prevents exfoliation of the thin-film encapsulation layer 250 from the organic light-emitting display apparatus 200 and increases the durability of the thin-film encapsulation layer 250. In addition, in an embodiment, the thin-film encapsulation layer 250 may, for example, contact an additional insulating layer or conductive layer formed on the upper surface of the substrate 201.

As the materials for forming the organic light-emitting device 220 and the thin-film encapsulation layer 250 of the present embodiment are the same as the materials for forming the organic light-emitting device 120 and the thin-film encapsulation layer 150 of the organic light-emitting display apparatus 100 described above in connection with FIG. 6, a detailed description thereof is omitted.

FIG. 8 is a schematic cross-sectional view of an organic light-emitting display apparatus 200' according to an embodiment of the present invention.

Referring to FIG. 8, the organic light-emitting display apparatus 200' may include, for example, a substrate 201', an organic light-emitting device 220', and a thin-film encapsulation layer 250'. The organic light-emitting device 220' may include, for example, a first electrode 221', a second electrode 222', and an intermediate layer 223'.

For convenience of description, differences between the organic light-emitting display apparatus 200 of FIG. 7 described above and the organic light-emitting display apparatus 200' of the present embodiment will be mainly described.

The thin-film encapsulation layer 250' is formed to have, for example, protruding edges. For example, a region of the thin-film encapsulation layer 250' contacting the substrate 201' protrudes to increase a contact area of the thin-film encapsulation layer 250' and the substrate 201'. The increase in the contact area of the thin-film encapsulation layer 250' and the substrate 201' prevents moisture, gas, and foreign substances from infiltrating into the thin-film encapsulation layer 250' and the substrate 201' and provides for a stable bond between the thin-film encapsulation layer 250' and the substrate 201', thereby increasing the durability of the thin-film encapsulation layer 250' and the organic light-emitting display apparatus 200'.

As the materials for forming the organic light-emitting device 220' and the thin-film encapsulation layer 250' of the present embodiment are the same as the materials for forming the organic light-emitting device 120 and the thin-film encapsulation layer 150 of the organic light emitting display apparatus 100 described above in connection with FIG. 6, a detailed description thereof is omitted.

As discussed, embodiments of the invention can provide a method of manufacturing a sputtering target, the method comprising: preparing a sputtering target material comprising a low temperature viscosity transition, LVT, inorganic material; melting the sputtering target material at a working pressure that is lower than atmospheric pressure; and processing the melted sputtering target material to thereby form the sputtering target.

In some embodiments, the LVT inorganic material includes a tin oxide and at least one other material selected from the group consisting of phosphorous oxide (P₂O₅), boron phosphate (BPO₄), tin fluoride (SnF₂), niobium oxide (NbO), and tungsten oxide (WO₃).

In some embodiments, the method comprises melting the sputtering target material in a vacuum state.

The melting operation may include performing a first temperature maintaining operation for maintaining a working temperature at a first temperature. The first temperature may be about 300 ° C to about 400 ° C for a time of about 1 hour to about 2 hours.

The melting operation may include performing a second temperature maintaining operation for maintaining the working temperature at a second temperature, after the first temperature maintaining operation. The second temperature may be about 800 ° C to about 850 ° C for a time of about 30 minutes to about 1 hour.

The melting operation may include performing a third temperature maintaining operation for maintaining the working temperature at a third temperature after the second temperature maintaining operation. The third temperature may be about 1000 °C to about 1200 °C.

The method may comprise processing the melted sputtering target material by cooling and drying the melted sputtering target material and cutting the dried sputtering target material into a desired shape to thereby form the sputtering target.

Embodiments of the invention can also provide a method of manufacturing an organic light-emitting display apparatus, the method comprising: forming an organic light-emitting device on a substrate, the organic light-emitting device comprising a first electrode, a second electrode, and an intermediate layer including an organic emission layer; and forming a thin-film encapsulation layer on the organic light-emitting device, the thin-film encapsulation layer comprising an inorganic layer including a low temperature viscosity transition (LVT) inorganic material, wherein the thin-film encapsulation layer is formed in a sputtering method using a sputtering target, the sputtering target comprising the LVT inorganic material.

In such embodiments, the sputtering target may manufactured by a method according to any one of the above mentioned embodiments.

As described above, according to embodiments of the present invention, in a method of manufacturing a sputtering target and a method of an organic light-emitting display apparatus, the characteristic of the sputtering target and the durability of the organic light-emitting display apparatus may be readily increased.

Having described exemplary embodiments of the present invention, it is further noted that it is readily apparent to those of ordinary skill in the art that various modifications may be made without departing from the scope of the invention which is defined by the metes and bounds of the appended claims.

## Claims

1. A method of manufacturing a sputtering target, the method comprising:
preparing a sputtering target material comprising a low temperature viscosity transition, LVT, inorganic material;
melting the sputtering target material at a working pressure that is lower than atmospheric pressure; and
processing the melted sputtering target material to thereby form the sputtering target.

2. The method of claim 1, wherein the working pressure for melting the sputtering target material is no greater than about 1000 Pa.

3. The method of claim 1 or 2, wherein the melting of the sputtering target material further comprises:
performing a first temperature maintaining operation for maintaining a working temperature at a first temperature ; and
performing a second temperature maintaining operation for maintaining the working temperature at a second temperature that is higher than the first temperature, after the first temperature maintaining operation.

4. The method of claim 3, wherein the melting of the sputtering target material further comprises gradually reducing the working pressure during the first temperature maintaining operation and gradually reducing the working pressure during the second temperature maintaining operation;
optionally wherein the working pressure is no greater than about 1 Pa during the first temperature maintaining operation and the second temperature maintaining operation.

5. The method of claim 3 or 4, wherein the melting of the sputtering target material further comprises increasing the working pressure and the working temperature after the first temperature maintaining operation and until the second temperature maintaining operation.

6. The method of any one of claims 3 to 5, wherein the melting of the sputtering target material further comprises increasing the working pressure and the working temperature until the first temperature maintaining operation.

7. The method of any one of claims 3 to 6, wherein the melting of the sputtering target material further comprises performing a third temperature maintaining operation for maintaining the working temperature at a third temperature that is higher than the second temperature, after the second temperature maintaining operation.

8. The method of claim 7, wherein the working pressure is maintained constant during the third temperature maintaining operation.

9. The method of claim 7 or 8, wherein the melting of the sputtering target material further comprises increasing the working pressure and reducing the working temperature after the third temperature maintaining operation.

10. The method of any one of claims 1 to 9, further comprising manufacturing powder for forming the sputtering target by using the melted sputtering target material , before the processing of the melted sputtering target material.

11. The method of any one of claims 1 to 10, wherein the LVT inorganic material of the sputtering target material comprises a tin oxide.

12. The method of any one of claims 1 to 12, comprising:
wherein the LVT inorganic material includes a tin oxide and at least one other material selected from the group consisting of phosphorous oxide (P₂O₅), boron phosphate (BPO₄), tin fluoride (SnF₂), niobium oxide (NbO), and tungsten oxide (WO₃), and the method comprising:
melting the sputtering target material in a vacuum state, wherein the melting operation includes performing a first temperature maintaining operation for maintaining a working temperature at a first temperature of about 300 ° C to about 400 ° C for a time of about 1 hour to about 2 hours, and performing a second temperature maintaining operation for maintaining the working temperature at a second temperature of about 800 °C to about 850 °C for a time of about 30 minutes to about 1 hour, after the first temperature maintaining operation and performing a third temperature maintaining operation for maintaining the working temperature at a third temperature of about 1000 ° C to about 1200 °C, after the second temperature maintaining operation; and
processing the melted sputtering target material by cooling and drying the melted sputtering target material and cutting the dried sputtering target material into a desired shape to thereby form the sputtering target.

13. A method of manufacturing an organic light-emitting display apparatus, the method comprising:
forming an organic light-emitting device on a substrate, the organic light-emitting device comprising a first electrode, a second electrode, and an intermediate layer including an organic emission layer; and
forming a thin-film encapsulation layer on the organic light-emitting device, the thin-film encapsulation layer comprising an inorganic layer including a low temperature viscosity transition (LVT) inorganic material,
wherein the thin-film encapsulation layer is formed in a sputtering method using a sputtering target, the sputtering target comprising the LVT inorganic material.

14. The method of claim 13, wherein the sputtering target is manufactured by a method according to any one of claims 1 to 12.

15. The method of claim 13 or 14, wherein the forming of the thin-film encapsulation layer comprises:
forming a preliminary thin-film encapsulation layer in the sputtering method using the sputtering target comprising the LVT inorganic material; and
healing the preliminary thin-film encapsulation layer, and
wherein the healing of the preliminary thin-film encapsulation layer is performed at a temperature that is no less than a viscosity transition temperature of the LVT inorganic material and lower than a denaturalization temperature of a material of the intermediate layer in the organic light-emitting device.
